# EUROPEAN PATENT APPLICATION

(11) **EP 4 350 765 A1**
(43) Date of publication of application: **10.04.2024**
(21) Application number: 22199970.9
(22) Date of filing: 06.10.2022
(51) Int. Cl.: H01L 23/495

(54) **A METHOD OF MANUFACTURING A SEMICONDUCTOR PACKAGE, SUCH SEMICONDUCTOR PACKAGE AS WELL AS AN ELECTRONIC SYSTEM COMPRISING A PCB ELEMENT AND AT LEAST SUCH SEMICONDUCTOR PACKAGE**

(71) Applicant: Nexperia B.V., 6534 AB Nijmegen (NL)
(72) Inventor: Poelma, Regnerus Hermannus, Nijmegen (NL); Wong, Wai Man, Guangdong (CN); Böttcher, Tim, 22529 Hamburg (DE); Funke, Hans-Juergen, 22529 Hamburg (DE); Entringer, Jannik, Hamburg (DE); Cheung, Yuet Keung, Hong Kong (HK); Chan, Chun Ning, Hong Kong (HK)
(74) Representative: Pjanovic, Ilija

(57) **Abstract**

Proposed is a method of manufacturing a semiconductor package having at least one semiconductor die connected with at least one conductive terminal, wherein the semiconductor package has an upper side and a bottom side and wherein the at least one terminal is located at least partially on the bottom side, the method comprising the steps of:
a) providing a lead frame having a plurality of terminals for establishing external electrical connections;
b) providing the at least one semiconductor die and electrically and mechanically attaching the at least one semiconductor die to the at least one terminal of the lead frame located at least partially on the bottom side;
c) providing an encapsulant over the semiconductor die and the plurality of terminals leaving at least a portion of at least one terminal exposed wherein on the bottom side the encapsulant is provided with at least one opening (8) that at least partially is exposing the semiconductor die; and
d) cleaning the bottom side of the semiconductor package;
e) partially plating a conductive layer on the bottom side, electrically connecting the semiconductor die via the at least one opening with the portion of at least one terminal exposed from the encapsulant; and
f) singulating the semiconductor package from the lead frame.

## Description

### TECHNICAL FIELD

The present disclosure relates to a method of manufacturing a semiconductor package, such semiconductor package as well as an electronic system comprising a PCB element and at least such semiconductor package.

### BACKGROUND OF THE DISCLOSURE

A known method of manufacturing a semiconductor device is disclosed in patent document US9303327B2. US9303327B2 further discloses a system, a packaged component, and a method for making a packaged component. In an embodiment of US9303327B2, a system comprises a component carrier, a component disposed on the component carrier and an insulating layer disposed on an electrically conductive surface of at least one of the component carrier or the component, wherein the insulating layer comprises a polymer and an inorganic material comprising a dielectric strength of equal or greater than 15 ac-kV/mm and a thermal conductivity of equal or greater than 15 W/m*K. Plating of a packaged component at the bottom side is disclosed. However, the resulting component does not have metal plated interconnection between the die and one of the leads (terminals).

A semiconductor device is disclosed in patent document US9218987B2, more precise a top-side cooled semiconductor package with stacked interconnection plate. The semiconductor package includes a circuit substrate with terminal leads, a semiconductor die atop the circuit substrate, a low thermal resistance intimate interconnection plate for bonding and interconnecting a top contact area of the semiconductor die with the circuit substrate, a low thermal resistance stacked interconnection plate atop the intimate interconnection plate for top-side cooling, and a moulding encapsulant for encapsulating the package except for exposing a top surface of the stacked interconnection plate to maintain effective top-side cooling. The top portion of the stacked interconnection plate can include a peripheral overhang above the intimate interconnection plate. The peripheral overhang allows for a maximized exposed top surface area for heat dissipation independent of otherwise areal constraints applicable to the intimate interconnection plate. The stacked interconnection plate can be partially etched or three dimensionally formed to create the peripheral overhang. The disclosed device of US9218987B2 relies on a 3D formed clip structure which needs to be assembled and needs additional parts to form a heatsink with the outside world.

Accordingly, it is a goal of the present disclosure to provide an improved semiconductor device with an integrated heatsink and electrical connection feature.

### SUMMARY OF THE DISCLOSURE

According to a first example of the disclosure, a method of manufacturing a semiconductor package having at least one semiconductor die connected with at least one conductive terminal is proposed. The semiconductor package has an upper side and a bottom side wherein at least one terminal is located at least partially on the bottom side. In particular, the method according to the disclosure comprises the steps of:
a) providing a lead frame having a plurality of terminals for external electrical connections;
b) providing at least one semiconductor die and electrically and mechanically attaching the at least one semiconductor die to the at least one terminal of the lead frame located at least partially on the bottom side ;
c) providing an encapsulant over the semiconductor die and the plurality of terminals leaving at least a portion of at least one terminal exposed wherein on the bottom side the encapsulant is provided with at least one an opening that at least partially is exposing the semiconductor die; and
d) cleaning the bottom side of the semiconductor package, followed by
e) partially plating a conductive layer on the bottom side, electrically connecting the semiconductor die via the at least one opening with the portion of at least one terminal exposed from the encapsulant.

Finally, the method comprises the step of:
f) singulating the semiconductor package from the lead frame.

In an advantageous example of the method according to the disclosure, in step b) the semiconductor die is attached to the terminal using eutectic bonding preferably CuSn eutectic, Ag containing adhesives or Ag sintering material. These bondings are lead (Pb) free connection methods, which make the finished semiconductor package RoHS compliant (restriction of hazardous materials).

Additionally, step b) can be further implemented with the step wherein the semiconductor die is provided with a metallic or polymer bump or film protruding from the bottom side.

In two further preferred steps of the method according to the disclosure, the opening in the encapsulant is formed during the encapsulating process or the opening in the encapsulant is formed using a laser cutting process.

Additionally, step e) can encompass the application of galvanic plating process or the application of electroless plating process, or sputtering or any other means of depositing an electrically conductive material.

Furthermore in an example of the method, the semiconductor package is trimmed by cutting off a portion of the semiconductor package having a lead terminal, which trimming step is performed before step f). Alternatively, the semiconductor package is trimmed by cutting off a portion of the semiconductor package having a terminal after step f).

The disclosure also relates to a semiconductor package manufactured according to the method of the disclosure, with the semiconductor package having a semiconductor die which is connected with at least one of conductive terminals, wherein the semiconductor package has an upper side and a bottom side and wherein at least one terminal at least partially is located on the bottom side.

The disclosure also relates to an electronic system comprising a PCB element provided with solder pads and at least one semiconductor package manufactured according to the method of the disclosure, with the semiconductor package being attached with the terminals to the PCB element via the solder pads.

### BRIEF DESCRIPTION OF THE DRAWINGS

The disclosure will now be discussed with reference to the drawings, which show in:
Figure 1 illustrates a schematic cross section of semiconductor package according to an example of the disclosure.
Figure 2 illustrates a schematic 3D view of semiconductor package having an opening 8 according to an example of the disclosure.

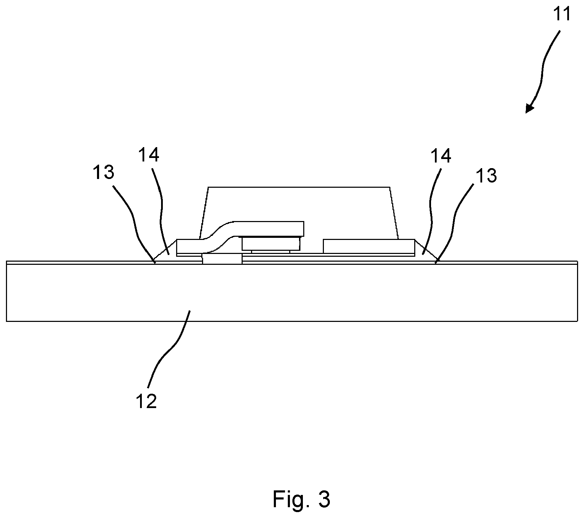

Figure 3 illustrates a schematic cross section of semiconductor system according to an example of the disclosure.
Figure 4a illustrates a schematic cross section of semiconductor package before trimming with the cutting line shown, 4b illustrates a schematic cross section of semiconductor package after trimming according to an example of the disclosure.
Figure 5 illustrates a schematic cross section of semiconductor package with die element having a bump 10 protruding from the upper side 4 according to an example of the disclosure.
Figure 6 illustrates a schematic cross section of semiconductor package with two die elements according to an example of the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

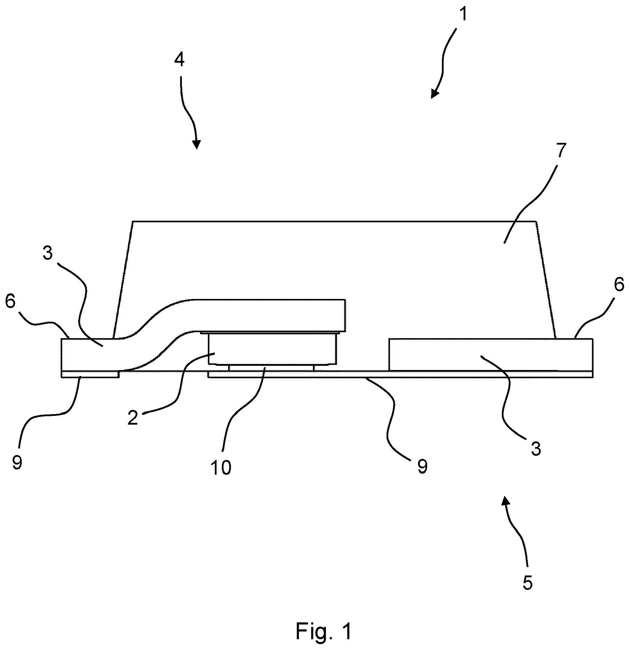

With reference to Figure 1, the first example of the disclosure pertains to a method of manufacturing a semiconductor package 1 having one semiconductor die 2. The semiconductor die 2, in the context of integrated circuits, is a small block of semiconducting material on which a given functional circuit is fabricated. Typically, integrated circuits are produced in large batches on a single wafer of electronic-grade silicon (EGS) or other semiconductor material (such as GaAs) through processes such as photo-lithography.

For the purpose of further usage in PCBs (Printed Circuit Board) or other electronics circuits, the semiconductor die 2 is connected with a plurality of conductive terminals 3. Those terminals 3 are protruding outside a semiconductor package 1 in any desired direction allowing mounting of the package 1 on a PCB and establishing electrical connections with the various terminals 3.

In another example, some terminals 3 are arranged in the manner that there is no part of terminal 3 protruding outside a semiconductor package 1, instead there are metallic (soldering enabled) parts of the terminals 3 exposed but not covered with the encapsulant 7 and accordingly suitable for being connected to the PCB using soldering alloy.

In this application, the phrase "terminal" is used in the meaning of any conductive layer outside of the semiconductor package 1 forming a pathway for the electric current or signal suitable for electrically connecting some part of the semiconductor package 1 with other parts of the electronic circuit (e.g. the PCB). Terminals 3 can also be referred as electrodes. A conductive layer 9, when connected to the terminal 3 or at least part of the die 2, can also be referred as terminal 3.

The semiconductor package 1 has an upper side 4 and a bottom side 5. However those sides are named only for easy reference and clarification as the semiconductor package 1 can be mounted to the PCB in different manners than here described.

In this example of a semiconductor package 1 of Figure 1, the terminal 3 is located on the bottom side 5 and it manufactured according to the method comprising the steps of:
a) providing a lead frame 6 having a plurality of terminals 3. The lead frame 6 is a metal web suitable for reel-to-reel process, but in another example it can be in a form of a metallic sheet. The lead frame is precut to form terminals 3 of different shape, some terminals 3 having larger dimensions (e.g. to match the dimensions of the die 2 or bigger leaving some additional space for the mounting process requirements of the die 2).

Terminals 3, suitable for mounting the die 2, are sometimes referred as paddles having a wider end portion. In this example the terminals 3, which are suitable for attaching the die elements 2, are bend toward the upper side 4 so that during further attachment steps, the bottom surface of the die element 2 matches (or nearly matches) the height of the surface of another terminal 3.

In a next step b), the semiconductor die 2 is provided and electrically and mechanically attached to the terminal 3 of the lead frame 6, which is located at the bottom side 5. In certain examples, the die 2 can be attached to the terminal 3 using a conductive adhesive, or a Cu based alloy (e.g. CuSn eutectic alloy) or an Ag based glue or an alloy or any other known material, as long as the materials used are suitable for providing a mechanical and electrical connection between the die element 2 and the corresponding terminal 3.

In a further step c), an encapsulant 7 is provided over the semiconductor die 2 and the terminals 3, wherein a portion of the terminals 3 are left exposed. The exposed portion of the terminal 3 serves for a soldering spot to establish a solder joint (or conductive glue joint) with the final semiconductor package 1 and a PCB. On the bottom side 5, the encapsulant 7 may be provided with an opening 8, such that the semiconductor die 2 is partially exposed. This opening forms a spot for depositing a metallic layer, which layer connects to the die 2.

The opening 8 may be formed in the particular spot on the die 2 for connecting the terminal 3. In another example more than one opening 8 can be provided. In this example, the encapsulant 7 is a thermoplastic polymer provided over the die 2 using transfer molding techniques, and the opening 8 can be created during shaping of the injection mold. Other molding techniques can be implemented as alternative manufacturing techniques, such as compression molding or injection molding.

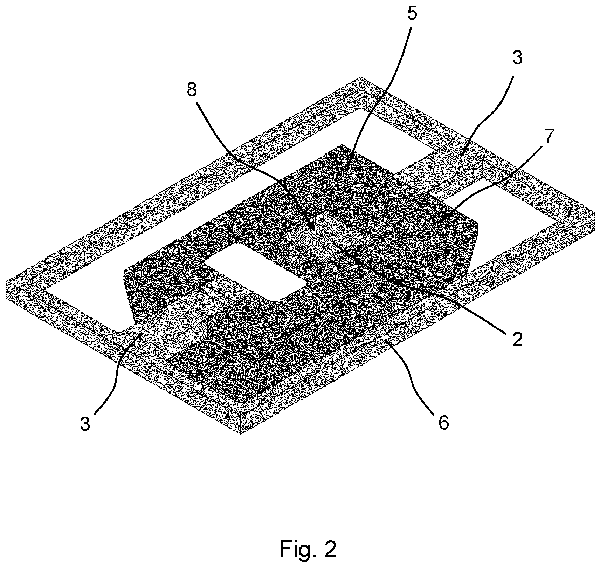

The injection form is shaped so that any injected encapsulant 7 is unable to cover the complete die element 2. Accordingly, during injection of the encapsulant 7, some spots are left uncovered and thus form the opening 8 as is shown in Figure 2.

A further step d) of the method according to the disclosure, pertains to cleaning the bottom side 5 of the semiconductor package in a wet process or a dry process. The cleaning process can also encompass or include a surface preparation step for the depositing of further metallic layers. It may also include the application of an surface activator material or solution.

The method according to the disclosure furthermore implements a step e) of partially plating a conductive layer 9 on the bottom side 5 in order to provide an electrically connection of the semiconductor die 2 via the opening 8 with the exposed portion of terminal 3, that is part of the terminal 3 being exposed from the encapsulant 7.

Finally, the method includes a singulating step f), wherein the semiconductor package 1 is separated from the lead frame 6. In this step some parts of the lead frame and terminals are removed (e.g. by trimming) and a final semiconductor package 1 is obtained, that matches the right standards. Some standards leave the terminals protruding the semiconductor package 1 (e.g. standards SOD123W, SOD323, SOD 323F) and some standards trim all the protruding terminals 3 off leaving only some part of the terminals 3 exposed thus not covered with encapsulant 7 (e.g. standard SOD882).

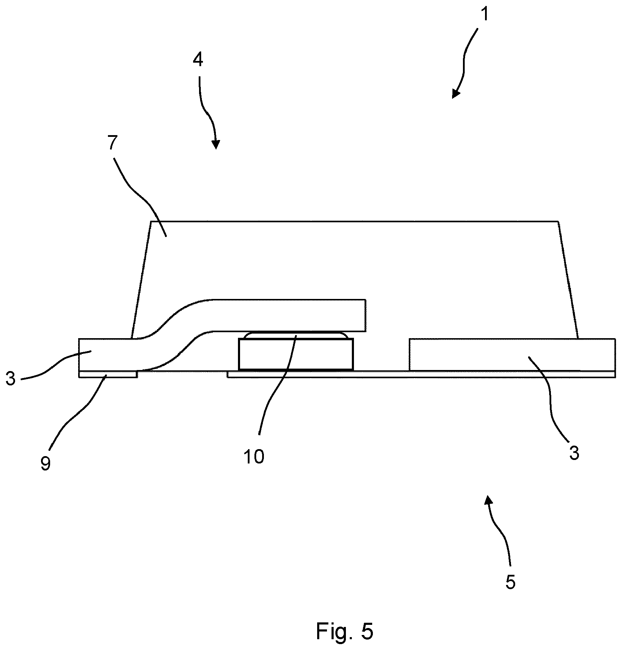

In another example of the disclosure, in step b) the semiconductor die 2 is provided with at least one metallic bump 10, which protrudes from the bottom side 5. This is also shown in Figure 1. However the semiconductor die 2 can be mounted with the metallic bump 10 protruding from the upper side 4, which example according to the disclosure is shown in Figure 5. The at least one metallic bump 10, which protrudes from the bottom side 5, can be in contact with the conductive terminal 3 or both.

In the alternative example, during step c), the encapsulant 7 is formed (e.g. by means of transfer molding) completely over the die element 2 without leaving any opening 8. In this example of the method according to the disclosure, the process requires another step to form the opening 8, e.g. by using a laser cutting process. A laser device removes, cuts though or burns out the encapsulant 7 at the specifics spot over the die component 2 to form an opening 8 at the bottom side 5.

In yet another example of the disclosure, in step e) the terminal 3 which not previously connected to the die element 2, is connected with the die element 2 via the opening 8 by depositing an metallic layer over the terminal 3, the opening 8 and over the portion of the encapsulant 9 in between. This step can be performed by any known method of depositing a metallic layer, including a galvanic plating process or an electroless plating process.

In an alternative example of the disclosure, a spot plating Cu seed layer process is applied. This process provides a Cu seed layer with a thickness of up to 300 nm, on which Cu seed layer galvanic layers with a larger thickness can be deposited. In another alternative example, a sputter masked Cu layer deposition process is applied for this step. This process provides a Cu seed layer with a thickness of up to 3 µm on which galvanic layers with a larger thickness can be deposited. The seed layer can also be provided over the complete bottom side 5 using any know technique and subsequently, several parts of the seed layer are removed using a masked Cu etching process.

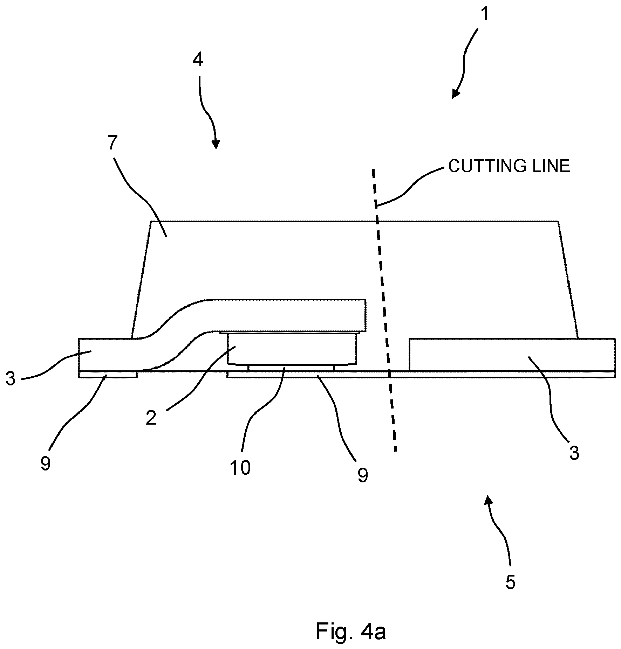

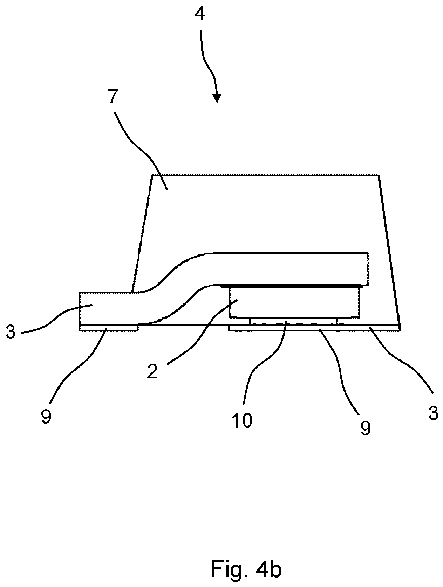

In a preferred example, the semiconductor package 1 is trimmed by cutting off a portion having a lead terminal of the semiconductor package 1 resulting in a semiconductor package 1 having reduced dimensions, as shown in Figure 4a and 4b. This process can be applied without any modifications before or after the singulating step f).

The disclosure also relates to a semiconductor package 1 having a semiconductor die 2 connected with a pair of conductive terminals 3. The semiconductor package 1 has an upper side 4 and a bottom side 5 wherein one terminal 3 is partially located on the bottom side 5. The semiconductor package 1 is manufactured in accordance with the process steps of the method of the disclosure as outlined above.

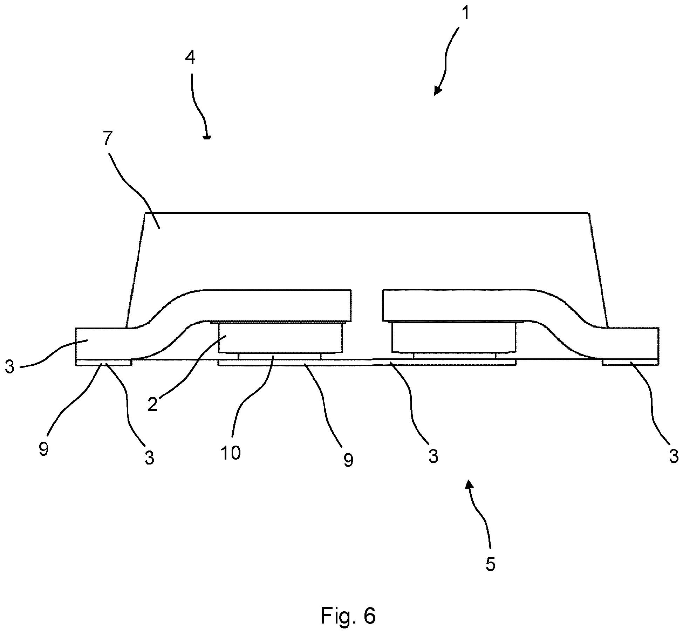

In another example, there may be two or more semiconductor dies 2 attached to the terminals 3, this example of implementing multiples dies 2 is shown in Figure 6.

The semiconductor package 1 as manufactured with the method according to the disclosure can be an element in an electronic system 11 (electronic device). The electronic system 11 may comprise a PCB element 12 provided with solder pads 13 and at least one semiconductor package 1 according to the disclosure, with the semiconductor package 1 being attached with the terminals 3 to the PCB element 12 via the solder pads. The PCB element 12 can be provided with a heatsink element placed (e.g. metal sheet) or formed (e.g. via thermal pads or via holes) nearby the opening 8 for improving any heat to be transferred from the die element 2 out of the semiconductor package 1.

### LIST OF REFERENCE NUMERALS USED

- 1: semiconductor package
- 2: semiconductor die
- 3: terminals
- 4: upper side of package
- 5: bottom side of package
- 6: lead frame
- 7: encapsulant
- 8: opening
- 9: conductive layer
- 10: bump
- 11: electronic system
- 12: PCB
- 13: solder pads
- 14: soldering alloy

## Claims

1. A method of manufacturing a semiconductor package (1) having at least one semiconductor die (2) connected with at least one conductive terminal (3), wherein the semiconductor package (1) has an upper side (4) and a bottom side (5) and wherein the at least one terminal (3) is located at least partially on the bottom side (5), the method comprising the steps of:
a) providing a lead frame (6) having a plurality of terminals (3) for establishing external electrical connections;
b) providing the at least one semiconductor die (2) and electrically and mechanically attaching the at least one semiconductor die to the at least one terminal (3) of the lead frame (6) located at least partially on the bottom side (5);
c) providing an encapsulant (7) over the semiconductor die (2) and the plurality of terminals (3) leaving at least a portion of at least one terminal (3) exposed wherein on the bottom side (5) the encapsulant (7) is provided with at least one opening (8) that at least partially is exposing the semiconductor die (2); and
d) cleaning the bottom side (5) of the semiconductor package;
e) partially plating a conductive layer (9) on the bottom side (5), electrically connecting the semiconductor die (2) via the at least one opening (8) with the portion of at least one terminal (3) exposed from the encapsulant (7);
f) singulating the semiconductor package (1) from the lead frame (6).

2. The method according to claim 1, wherein in step b) the semiconductor die (2) is attached to the terminal (3) using eutectic bonding preferably CuSn eutectic or Ag containing adhesives or Ag sintering material.

3. The method according to claim 1 or 2, wherein in step b) the semiconductor die (2) is provided with at least one metallic bump (10) protruding from the bottom side (5).

4. The method according to claim 1, 2 or 3, wherein the opening (8) in the encapsulant (7) is formed during the encapsulating process.

5. The method according to claim 1,2 or 3, wherein the opening (8) in the encapsulant (7) is formed using a laser cutting process.

6. The method according to any of proceedings claims from 1 to 5, wherein in the step e) galvanic plating process is applied.

7. The method according to any of proceedings claims from 1 to 5, wherein in the step e) electroless plating process is applied.

8. The method according to any of proceedings claims from 1 to 7, wherein before step f) the semiconductor package (1) is trimmed by cutting off a portion of the semiconductor package having a lead terminal.

9. The method according to any of proceedings claims from 1 to 7, wherein after step f) the semiconductor package (1) is trimmed by cutting off a portion of the semiconductor package (1) having a terminal (3).

10. A semiconductor package (1) having at least one semiconductor die (2) connected with at least one conductive terminal (3), wherein the semiconductor package (1) has an upper side (4) and a bottom side (5), wherein at least one terminal (3) at least partially is located on the bottom side (5) manufactured by process according to any of claims from 1 to 9.

11. An electronic system (11) comprising a PCB element (12) provided with solder pads (13) and at least one semiconductor package (1) according to claim 10, with the at least one semiconductor package (1) being attached with the terminals (3) to the PCB element (12) via the solder pads.
